Europäisches Patentamt

European Patent Office

Office européen des brevets

(11) Numéro de publication: **0 436 829 A2**

# (12) DEMANDE DE BREVET EUROPEEN

(21) Numéro de dépôt: 90123073.0

(22) Date de dépôt: 03.12.90

(51) Int. Cl.⁵: **H01L 29/14**, H01L 29/205

(30) Priorité: 07.12.89 FR 8916190

(43) Date de publication de la demande:
**17.07.91 Bulletin 91/29**

(84) Etats contractants désignés:
**DE FR GB IT NL**

(71) Demandeur: **ALCATEL ALSTHOM COMPAGNIE GENERALE D'ELECTRICITE**
**54, rue La Boétie**
**F-75382 Paris Cédex 08(FR)**

(72) Inventeur: **Le Mehaute, Alain**
**90, allée Bannière de Maupertuis**
**F-91190 Gif Sur Yvette(FR)**

(74) Mandataire: **Weinmiller, Jürgen et al**
**Lennéstrasse 9 Postfach 24**
**W-8133 Feldafing(DE)**

(54) **Structure de puits quantique.**

(57) Structure de puits quantique, caractérisée par le fait qu'elle comprend deux types de puits quantiques, en interaction quantique frustrée, dont les longueurs caractéristiques les plus faibles sont de l'ordre de la dizaine à quelques dizaines d'angströms, et tels que le rapport de leurs dimensions au sens de Mandelbrot soit égal à $2 \pm 0{,}3$, et que leurs conductivités respectives présentent plusieurs ordres de grandeur d'écart.

FIG.1

## STRUCTURE DE PUITS QUANTIQUE

La présente invention concerne une structure de puits quantique susceptible d'être utilisée dans un circuit électronique grâce à ses propriétés de supraconductivité.

A l'heure actuelle se pose le problème de la conduction dans les circuits électroniques de haute capacité, car l'énergie dissipée est trop importante. Il peut être envisagé d'utiliser des liaisons supraconductrices de l'ordre du micron ou inférieures au micron, mais elles sont difficiles à mettre en oeuvre à partir des matériaux supraconducteurs connus.

La présente invention a pour but d'éviter cet inconvénient.

La présente invention a pour objet une structure de puits quantique caractérisée par le fait qu'elle comprend deux types de puits quantiques, en interaction quantique frustrée, dont les longueurs caractéristiques les plus faibles sont de l'ordre de la dizaine ou de quelques dizaines d'angströms, et tels que le rapport de leurs dimensions au sens de Mandelbrot soit égal à 2 + 0,3, et que leurs conductivités respectives présentent plusieurs ordres de grandeur d'écart.

On appelle "interaction quantique frustrée" l'existence de phénomènes d'interaction entre les ondes quantiques associées à la propagation des électrons dans les deux structures quantiquement associées. Les fondements théoriques des interactions dans chacune des structures sont décrits notamment dans le "Journal of Statistical Physics", vol. 36, Nov. 1984, pages 665 et suivantes, par Alain Le Méhauté.

La "dimension au sens de Mandelbrot" est définie dans son ouvrage "Les Fractals", Flammarion 1975 : La dimension d'une structure est le coefficient en puissance d'une longueur l telle que le contenu géométrique c de la structure dans l'espace soit donné par $c = l^d$.

Dans le cas présent la structure selon l'invention n'est pas caractérisée par une valeur de sa dimension, mais elle est fabriquée de telle sorte qu'elle ait deux structures en interactions, chacune ayant sa propre dimension. Il existe donc deux dimensions dans le système et l'onde peut dans ces conditions être frustrée au plan de la métrique, parce qu'elle n'arrivera pas à remplir les deux conditions géométriques en même temps. Il peut être montré dans ce cas que chacun des puits quantiques peut fournir à l'autre une métrique de paramétrisation de son espace.

Une condition à remplir pour avoir une structure globale supraconductice est que la "paramétrisation" soit associée à l'espace de dimension la plus faible et que la mesure de l'espace soit associée à l'espace de dimension la plus grande. Ceci est réalisé si le rapport des conductivités des deux structures de puits quantiques est par exemple de l'ordre de $10^4$. Un matériau selon l'invention présente alors des caractéristiques de supraconductivité à une température de transition définie par $Tc = (\lambda c/\lambda p)^d \times (h/k)$ où :
$\lambda c$ est la "conductivité" sur la structure de dimension la plus faible
$\lambda p$ est la "conductivité" sur la structure de dimension la plus grande h et k étant les constantes quantiques habituelles
$d = dpdc/dp\text{-}dc$ si dp et dc sont les dimensions respectivement la plus élevée et la plus faible.

Selon un exemple de mise en oeuvre, le premier puits quantique a une dimension égale à deux et le second puits quantique une dimension égale à 1.

Un puits quantique de dimension égale à 2 est réalisé par un matériau dont une épaisseur est suffisamment faible pour que la propagation transversale des ondes quantiques soit perturbée et ne réponde plus à un modèle de bande. Cette épaisseur peut être de l'ordre de 50 Å. Le puits quantique de dimension égale à 1 peut être une ligne quantique d'épaisseur de l'ordre de 50 Å.

Selon un autre exemple de mise en oeuvre, le premier type de puits quantique est un arrangement fractal de lignes quantiques de dimension comprise entre 1 et 2, et ledit second puits quantique comprend un plan quantique associé à des boîtes quantiques dont la distribution a une dimension comprise entre 0 et 1. Un tel arrangement fractal et les boîtes quantiques sont définis dans l'ouvrage de Mendelbrot "The geometry of Nature" 1982 Ed Friman (Cantor Dust).

Selon un premier mode de réalisation les matériaux desdits puits quantiques sont constitués d'atomes de type III-V. Ces matériaux répondent aux formules suivantes : $GaAs$, $Al_{1-x} Ga_x As$, $Ga_z In_{1-z} As$, $Ga_y In_{1-y} As_x P_{1-x}$, $Ga As_x P_{1-x}$, et aux formules analogues où As est remplacé au moins en partie par Sb.

Selon un autre mode de réalisation, ledit premier puits quantique est constitué par un composé bidimensionnel de type graphite, $TiS_2$, $NiPS_3$.
Ledit second puits quantique peut être réalisé en un polymère conducteur qui ne présente, lors de sa synthèse, que deux sites de croissance ; un tel polymère peut être choisi parmi le polyacétylène, le polythiophène, la polyaniline, le polyparaphénylène, le polysulfure de phénylène. Il existe aussi des matériaux inorganiques présentant cette propriété ; l'archétype de ces matériaux est le composé au niobium $NbS_3$.

D'autres caractéristiques et des avantages de la présente invention apparaîtront au cours de la description suivante de modes de réalisation donnés à titre illustratif, mais nullement limitatif.

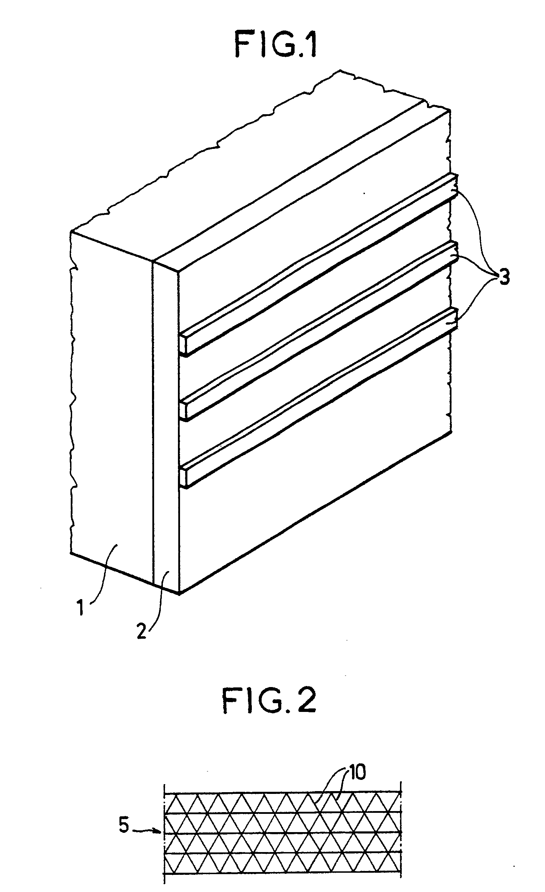

Dans le dessin annexé, les figures 1 et 2 montrent très schématiquement des exemples de structure selon l'invention.

Dans la figure 1, on part d'un support 1 en arséniure de gallium GaAs. Par la technique connue sous le nom de MBE (Molecular Beam Epitaxy), ou le nom de EJM "Epitaxie par jets moléculaires", on fait croître sur la surface du support 1 un film 2 d'$Al_{1-x}Ga_xAs$, dont l'épaisseur est comprise entre 10 et 100 angströms, de préférence 50 angströms. Ce procédé est décrit dans l'article paru dans "Physics World 2 July 1989" pages 39 à 42 : Superlattice surprises par John Orton." On obtient ainsi une première structure de nature bidimensionnelle.

Sur le film 2 on dépose, soit au moyen de la MBE, soit à l'aide d'un microscope TUNNEL présentant une résolution égale à 1 angström, des lignes 3 en $Al_{1-y}Ga_yAs$ de largeur et d'épaisseur 50 angströms. Les valeurs de x et de y sont choisies telles que :

$$x \neq y \quad \text{et } 0,1 < x < 0,99$$
$$0,1 < y < 0,99$$

De préférence :
x = 0,75 $\overline{+}$ 0,2
y = 0,75 $\overline{+}$ 0,2.

La partie vide entre les différentes lignes est remplie soit par GaAs, soit par un composé de teneur en aluminium différente.

La technique d'utilisation du microscope TUNNEL est décrite notamment dans l'article "Nanolithography with high resolution STEM" de C.P. Umbach et al, paru dans IBM J. Res. Developt vol. 32, n° 4, juillet 1988.

On a ainsi réalisé des structures de dimension égale à 1 sur une structure de dimension égale à 2.

Le procédé est répété autant de fois qu'il est nécessaire pour obtenir en fin d'opération une structure ayant la taille microscopique de quelques microns d'épaisseur.

Selon un autre exemple, on réalise sur un substrat de GaInAsP une structure de puits quantiques 2D et 1D telle que le puits quantique 2D soit en $Ga_zIn_{1-z}As$ et que le puits quantique 1D soit en $Ga_yIn_{1-y}As_xP_{1-x}$. Le vide entre les différentes lignes quantiques est rempli de GaAs.

Les valeurs de x, y, z sont choisies de façon que :

0,7 < x < 0,99
0,3 < y < 0,99
0,7 < z < 0,99
avec de préférence :
x = 0,9 ; y = 0,9 ; z = 0,9.

Un avantage de la structure selon l'invention est que la "conductivité" des lignes et des plans peut être modifiée à volonté en jouant sur les taux de dopages. On observera cependant que la notion de conductivité est à ce niveau quantique très difficile à définir, comme il est très bien montré par Landauer (voir IBM J. Res. Develop. 32 (3) (1988) 384 "what is measured when you measure a resistance : the Landauer formula revisited"). Néanmoins si l'on s'en tient aux définitions habituelles, dimensionnées correctement, c'est-à-dire que λc s'exprime comme une vitesse et λp s'exprime comme un coefficient de diffusion, le rapport typique à obtenir λ c/ λp doit être tel que :

$$\lambda c / \lambda p \neq 2.10^{-4}.$$

Dans ces conditions Tc est de l'ordre de la centaine de Kelvin.

Pour être appliquée comme supraconducteur dans des circuits électroniques susceptibles de fonctionner à basse température, la structure selon l'invention doit présenter un rapport de conductivité entre le plan quantique et la ligne quantique compris entre $10^{-3}$ et $10^{-5}$.

Plusieurs centaines de structures de ce genre peuvent être empilées les unes sur les autres.

La figure 2 montre partiellement en vue de dessus, un arrangement fractal 5 de lignes quantiques 10. Ces lignes, analogues aux lignes 3 de la figure 1, présentent une épaisseur de 50 angströms et peuvent définir des triangles allant jusqu'à 100 angströms de côté.

La dimension $d_1$ de ce puits quantique est égale à

$$\frac{Ln3}{Ln2}$$

Cet arrangement fractal peut être associé à un plan quantique associé à des boîtes quantiques dont la distribution a une dimension $d2 = \frac{1}{2}$

$$\frac{Ln3}{Ln2}.$$

Bien entendu l'invention n'est pas limitée aux exemples décrits ci-dessus.

**Revendications**

1. Structure de puits quantique, comprenant au moins deux types de puits quantiques dont les longueurs caractéristiques les plus faibles sont de l'ordre de la dizaine à quelques dizaines d'angströms, et tels que le rapport de leurs dimensions au sens de Mandelbrot soit égal à $2 \pm 0,3$, caractérisée par le fait que les conductivités respectives de ces puits quantiques présentent plusieurs ordres de grandeur d'écart et qu'ils sont ainsi en interaction quantique frustrée.

2. Structure de puits quantique selon la revendication 1, caractérisée par le fait que le premier type de puits quantique a une dimension égale à deux et que le second type de puits quantique a une dimension égale à un.

3. Structure de puits quantique selon la revendication 2, caractérisée par le fait que ledit premier puits quantique est un plan quantique dont l'épaisseur est voisine de 50 Å, et que ledit second puits quantique est une ligne quantique dont les épaisseurs sont voisines de 50 Å.

4. Structure de puits quantique selon l'une des revendications 1 et 2, caractérisée par le fait que le premier type de puits quantique est un arrangement fractal de lignes quantiques de dimension comprise entre 1 et 2, et que ledit second puits quantique comprend un plan quantique associé à des boîtes quantiques dont la distribution a une dimension comprise entre 0 et 1.

5. Structure de puits quantique selon l'une des revendications 1 à 4, caractérisée par le fait que les matériaux desdits puits quantiques sont constitués d'atomes de type III-V.

6. Structure de puits quantique selon la revendication 5, caractérisée par le fait que lesdits matériaux répondent à l'une des formules suivantes :
$GaAs$, $Al_{1-x}Ga_xAs$, $Ga_zIn_{1-z}As$, $Ga_y In_{1-y} As_x P_{1-x}$, $Ga As_x P_{1-x}$, et aux formules analogues où As est remplacé au moins en partie par Sb.

7. Structure de puits quantique selon la revendication 2, caractérisée par le fait que ledit premier puits quantique est constitué par un composé bidimensionnel de type graphite, $TiS_2$, $NiPS_3$.

8. Structure de puits quantique selon l'une des revendications 2 et 3, caractérisée par le fait que ledit second puits quantique est réalisé en $NbS_3$, ou en un polymère conducteur choisi parmi le polyacétylène, le polythiophène, la polyaniline, le polyparaphénylène, le polysulfure de phénylène.

9. Structure de puits quantique selon l'une des revendications 2 à 8, caractérisée par le fait que le rapport des conductivités entre le puits quantique de dimension 2 et le puits quantique de dimension 1 est compris entre $10^{-3}$ et $10^{-4}$.

10. Application de la structure selon les revendications 1 à 9 comme supraconducteur.

11. Matériau caractérisé par le fait qu'il comporte plusieurs centaines de structures élémentaires selon l'une des revendications précédentes, lesdites structures étant empilées les unes sur les autres.

# FIG.1

# FIG.2